# EUROPEAN PATENT APPLICATION

(11) **EP 3 041 135 A1**
(43) Date of publication of application: **06.07.2016**
(21) Application number: 14200669.1
(22) Date of filing: 30.12.2014
(51) Int. Cl.: H03F 3/195, H03F 3/45, H03F 1/56, H03F 3/60, H03F 1/02, H04B 1/18

(54) **Active balun and monolithic microwave integrated circuit incorporating the same for ultra-wide band reception**

(71) Applicant: Elettronica S.p.A., 00131 Roma (IT)
(72) Inventor: Trotta, Fabrizio, 00131 ROMA (IT); Bartocci, Marco, 00131 ROMA (IT); Tafuto, Antonio, 00131 ROMA (IT)
(74) Representative: Boggio, Luigi

(57) **Abstract**

Disclosed herein is a MMIC (200) that includes: an input stage designed to be connected to a microwave antenna to receive therefrom a balanced microwave signal; a differential amplifier (205) connected to the input stage and designed to output, in response to reception of the balanced microwave signal, a corresponding unbalanced microwave signal; a single-ended amplifier (209) connected to the differential amplifier (205); an output matching and biasing network (210), which is connected to the single-ended amplifier (209) to receive therefrom the amplified balanced microwave signal, and which is designed to be connected to a microwave transmission line to provide the latter with said amplified unbalanced microwave signal and receive therefrom a direct current power supply, to perform impedance matching between the single-ended amplifier (209) and said microwave transmission line, and bias the single-ended amplifier (209) on the basis of the direct current power supply.

## Description

### TECHNICAL FIELD OF THE INVENTION

The present invention relates, in general, to Ultra-Wide Band (UWB) reception, and, in particular, to an active balun and a Monolithic Microwave Integrated Circuit (MMIC) incorporating the same for use in UWB reception.

### BACKGROUND ART

As is known, UWB Electronic Warfare (EW) systems are designed to cover an extremely wide band of the frequency spectrum (i.e., multiple octaves). For example, UWB EW systems, such as UWB Electronic Counter-Measure (ECM) systems, can be designed to cover microwave bands from 0.5 GHz to 18 GHz (i.e., NATO bands from C to J), which correspond to a relative bandwidth of 36:1.

UWB multi-octave systems often cause difficulties in designing Radio Frequency (RF) components especially for electromagnetic transmissions with minimized group delays. Among these difficulties, one of the key issues for UWB EW systems is the design of directional antennas for a multi-octave bandwidth. Currently, UWB EW systems exploit such antennas as Tapered Slot Antennas (TSA), Vivaldi antennas, spiral antennas, and sinuous antennas. In particular, use of planar self-complementary antennas, such as spiral and sinuous antennas, has recently demonstrated significant performances which are hardly achievable with the other types of antennas. In this connection, examples of known spiral and sinuous antennas are disclosed in:
- US 6,023,250 A, which relates to a compact, phasable, multi-octave, planar, high-efficiency, spiral mode antenna;
- US 4,658,262 A, which relates to a dual polarized sinuous antenna; and
- EP 2 629 367 A1, which relates to a UWB low-profile sinuous slot antenna array.

As is known, most of the UWB antennas currently used for EW applications, such as ECM applications, are designed to provide, upon reception, differential mode (i.e., balanced mode) microwave incoming signals, while these antennas are normally connected to respective receiving modules through unbalanced microwave transmission lines, such as coaxial cables or microstrip lines. Moreover, EW systems usually employ balanced UWB antennas and unbalanced microwave transmission lines having different impedances.

Therefore, in EW systems a microwave passive balun transformer is generally used to interface a balanced UWB antenna, such as a Vivaldi, spiral or sinuous antenna, with an unbalanced microwave transmission line.

In fact, as is known, a balun is a three-port device that converts between a balanced signal, i.e., a differential signal (such as microwave incoming signals provided, upon reception, by a UWB antenna of the aforesaid type), and an unbalanced signal (such as signals propagating through coaxial cables or microstrip lines). If necessary, a balun can also include an impedance transformer for performing impedance matching and, in this case, can be called balun transformer.

Currently known EW systems include baluns (or balun transformers) made up of microwave passive components, which have large size (such as of several square centimeters), relatively narrow bandwidth and high losses. In particular, these baluns are characterized by a maximum linear geometric size *Lₘₐₓ* defined by the respective maximum operating wavelength λ*ₘₐₓ* (i.e., the respective minimum operating frequency) of said baluns (and, thence, of the EW systems employing these latter), so that it results that *Lₘₐₓ*≈λ*ₘₐₓ*.

Moreover, also currently known microwave passive impedance transformers are large-sized.

Therefore, microwave passive balun transformers, baluns and impedance transformers currently exploited in EW systems are large-sized and unable to cover the aforesaid relative bandwidth of 36:1 with minimum group delay, thereby heavily affecting size, frequency coverage and performance of the EW systems employing these devices.

Moreover, as is known, receiving modules are used in EW systems to process microwave signals received by UWB antennas, which receiving modules are:
- connected, as previously explained, to said UWB antennas through unbalanced microwave transmission lines, such as coaxial cables or microstrip lines; and
- usually equipped with
   - a limiter for protection against high power signals received (such as high power interfering/jamming signals), and
   - a broadband low-noise amplifier with minimized group delay.

In summary, microwave UWB reception requires four important functions, i.e., balanced-to-unbalanced signal conversion, impedance matching, protection against high power signals, and broadband low-noise amplification. In currently known EW systems said four functions are carried out by means of three or four discrete devices, in particular:
- balanced-to-unbalanced signal conversion and impedance matching are carried out by means of a single microwave passive balun transformer, or a microwave passive balun and a microwave passive impedance transformer, arranged between the UWB antenna and the microwave transmission line; and
- protection against high power signals and broadband low-noise amplification are carried out by means of, respectively, a limiter and a broadband low-noise amplifier arranged between the microwave transmission line and the receiving module.

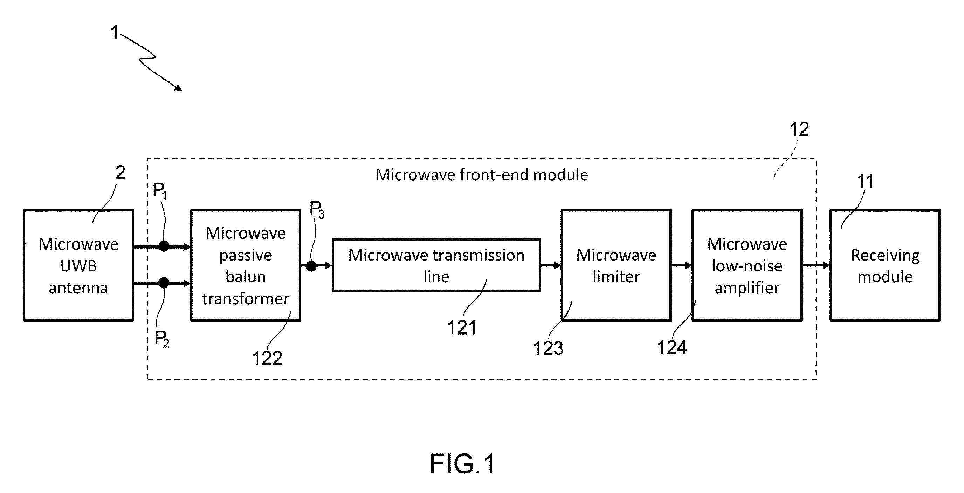

For a better understanding of the foregoing, Figure 1 shows a block diagram schematically representing a typical architecture of a traditional UWB receiver (denoted as a whole by 1) for EW applications.

In particular, as shown in Figure 1, the UWB receiver 1 comprises a receiving module 11 connected to a microwave UWB antenna 2 (such as a Vivaldi, spiral or sinuous antenna) through a microwave front-end module 12, which includes:
- a microwave transmission line 121, such as a coaxial cable or a microstrip line;
- a microwave passive balun transformer 122, which
   - includes
      - two input ports P₁ and P₂ coupled with the microwave UWB antenna 2 to receive therefrom differential (i.e., balanced) microwave incoming signals, and
      - an output port P₃ coupled with the microwave transmission line 121 to provide the latter with corresponding unbalanced microwave incoming signals, and
   - is designed to
      - convert the balanced microwave incoming signals to said corresponding unbalanced microwave incoming signals, and
      - match the impedance of the microwave UWB antenna 2 to the impedance of the microwave transmission line 121;
- a microwave limiter 123, which is
   - coupled with the microwave transmission line 121 to receive therethrough the unbalanced microwave incoming signals, and
   - designed to reject high power signals received; and
- a microwave low-noise amplifier 124, which is
   - coupled with the microwave limiter 123, and
   - designed to perform low-noise amplification of the microwave signals received from said microwave limiter 123.

As previously explained, balanced-to-unbalanced signal conversion and impedance matching could also be carried out by means of a microwave passive balun and a microwave passive impedance transformer in place of the single microwave passive balun transformer 122.

### OBJECT AND SUMMARY OF THE INVENTION

An object of the present invention is that of providing a microwave device for use in microwave front-end modules of, in general, UWB systems and, in particular, UWB receivers, which microwave device enables to reduce size, increase frequency coverage and improve performance of microwave front-end modules and UWB systems/receivers.

This and other objects are achieved by the present invention in that it relates to a Monolithic Microwave Integrated Circuit (MMIC), as defined in the appended claims.

In particular, the MMIC according to the present invention includes:
- an input stage designed to be connected to a microwave antenna to receive therefrom a balanced microwave signal;
- a differential amplifier connected to the input stage and designed to output, in response to reception of the balanced microwave signal, a corresponding unbalanced microwave signal;
- a single-ended amplifier connected to the differential amplifier and designed to amplify the unbalanced microwave signal outputted by the latter;

- an output matching and biasing network, which is connected to the single-ended amplifier to receive therefrom the amplified balanced microwave signal, and which is designed to
   - be connected to a microwave transmission line to provide the latter with said amplified unbalanced microwave signal and receive therefrom a direct current power supply,
   - perform impedance matching between the single-ended amplifier and said microwave transmission line, and
   - bias the single-ended amplifier on the basis of the direct current power supply; and
- a biasing network, which is connected to the output matching and biasing network to receive therefrom said direct current power supply, and which is designed to bias the differential amplifier on the basis of said direct current power supply.

Preferably, the input stage includes:
- two input ports designed to be coupled with the microwave antenna to receive the balanced microwave signal;
- two limiters, each connected to a respective one of the two input ports; and
- two input impedance matching networks, each of which is connected between
   - a respective one of the two limiters, and
   - a respective input of the differential amplifier;
   wherein the input impedance matching networks are designed to perform impedance matching between the microwave antenna and the differential amplifier.

More preferably, the MMIC according to the present invention has the following features:
- the differential amplifier includes a first field-effect transistor and a second field-effect transistor, each of which has respective gate, drain and source electrodes;
- the single-ended amplifier includes a third field-effect transistor having respective gate, drain and source electrodes;
- the gate electrodes of the first and second field-effect transistors are connected, each, to a respective one of the two input impedance matching networks to receive the balanced microwave signal;
- the source electrode of the first field-effect transistor is connected to the source electrode of the second field-effect transistor;
- the drain electrode of the first field-effect transistor is connected to the gate electrode of the third field-effect transistor through a first matching and biasing network to provide said third field-effect transistor with the unbalanced microwave signal;
- the drain electrode of the second field-effect transistor is connected to a grounded impedance through a second matching and biasing network;
- the output matching and biasing network is connected to the drain electrode of the third field-effect transistor to receive therefrom the amplified unbalanced microwave signal and to bias said third field-effect transistor;
- the first matching and biasing network is connected to the biasing network to receive therefrom the direct current power supply, and is designed to
   - perform impedance matching between the first field-effect transistor and the third field-effect transistor, and
   - bias the first field-effect transistor on the basis of said direct current power supply; and
- the second matching and biasing network is connected to the biasing network to receive therefrom the direct current power supply, and is designed to
   - perform impedance matching between the second field-effect transistor and the grounded impedance, and
   - bias the second field-effect transistor on the basis of said direct current power supply.

### BRIEF DESCRIPTION OF THE DRAWINGS

For a better understanding of the present invention, preferred embodiments, which are intended purely by way of example and are not to be construed as limiting, will now be described with reference to the attached drawings (all not to scale), where:
- Figure 1 schematically illustrates a typical architecture of a UWB receiver for EW applications according to the background art;
- Figure 2 schematically illustrates a MMIC according to a preferred embodiment of the present invention for use in a microwave front-end module of, in general, a UWB system and, in particular, a UWB receiver; and
- Figures 3 and 4 show, respectively, S-parameters and Noise Figure of the MMIC shown in Figure 2.

### DETAILED DESCRIPTION OF PREFERRED EMBODIMENTS OF THE INVENTION

The following discussion is presented to enable a person skilled in the art to make and use the invention. Various modifications to the embodiments will be readily apparent to those skilled in the art, without departing from the scope of the present invention as claimed. Thus, the present invention is not intended to be limited to the embodiments shown and described, but is to be accorded the widest scope consistent with the principles and features disclosed herein and defined in the appended claims.

The Applicant has carried out an in-depth study on microwave front-end components of UWB EW systems in order to try to reduce size, increase frequency coverage and improve performance of these latter. Thanks to this in-depth study the Applicant has succeeded in conceiving and realizing the present invention, that relates to a microwave active balun and a MMIC incorporating the same, which microwave active balun and MMIC enable to reduce size, increase frequency coverage and improve performance of microwave front-end modules and, thence, of UWB systems, specifically UWB receivers, employing these latter.

In particular, an aspect of the present invention concerns a miniaturized microwave UWB active balun designed to cover the aforesaid relative bandwidth of 36:1 with minimum group delay.

Moreover, a further aspect of the present invention concerns a MMIC, that:
- incorporates said microwave UWB active balun for balanced-to-unbalanced signal conversion; and
- is designed also to carry out the other three functions necessary for microwave UWB reception, i.e., impedance matching, protection against high power signals, and broadband low-noise amplification with minimized group delay.

Preferably, the MMIC is manufactured by using gallium arsenide (GaAs) pseudomorphic High-Electron-Mobility Transistor (pHEMT) technology.

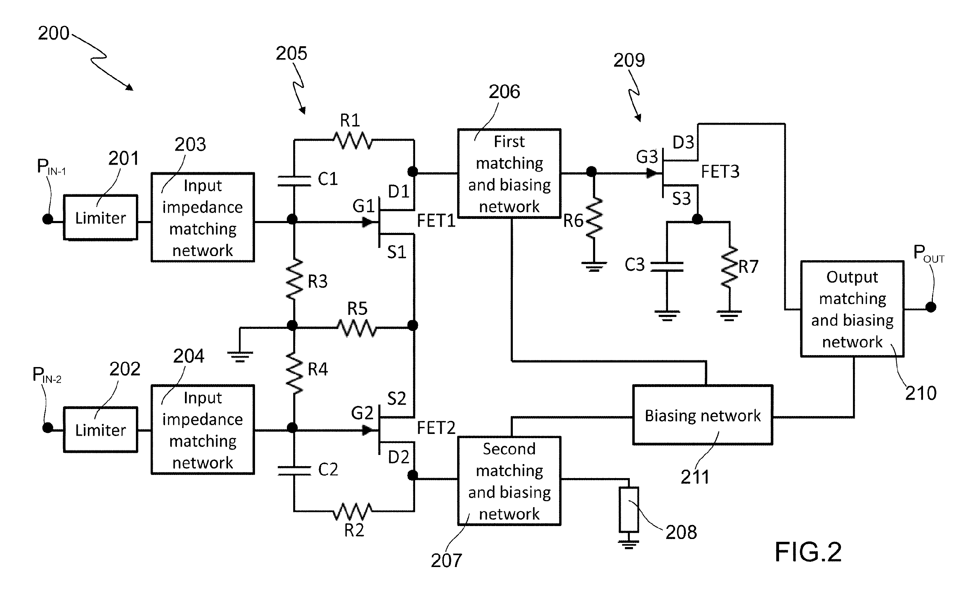

For a better understanding of the present invention, Figure 2 shows a circuit block diagram schematically representing an architecture of a MMIC (denoted as a whole by 200) according to a preferred embodiment of the present invention for use in a microwave front-end module of, in general, a UWB system and, in particular, a UWB receiver.

In particular, the MMIC 200 includes:
- two input ports P_{IN-1} and P_{IN-2} designed to be coupled with a microwave UWB antenna (not shown in Figure 2), conveniently a planar self-complementary antenna, such as a spiral or sinuous antenna, to receive therefrom differential (i.e., balanced) microwave incoming signals; and
- an output port P_{OUT} designed to be coupled with a microwave transmission line (not shown in Figure 2), preferably a coaxial cable, to provide the latter with unbalanced microwave signals and to receive therefrom a single Direct Current (DC) power supply for biasing all active components of the MMIC 200; preferably this single DC power supply is taken from the central conductor of the coaxial cable.

Preferably, the MMIC 200 is designed to be driven by a self-complementary antenna with a balanced mode for an input impedance of 150 Ω, which self-complementary antenna is designed to receive microwave signals having frequencies comprised in the range 0.5-18 GHz (i.e., NATO bands from C to J), and, thence, to cover, as previously explained, a relative bandwidth of 36:1.

The MMIC 200 further includes:
- two limiters 201 and 202, each connected to a respective one of the two input ports P_{IN-1} and P_{IN-2} (in particular, as shown in Figure 2, the limiter 201 is connected to the input port P_{IN-1} and the limiter 202 is connected to the input port P_{IN-2}) ;
- two input impedance matching networks 203 and 204, each connected to a respective one of the two limiters 201 and 202 (in particular, as shown in Figure 2, the input impedance matching network 203 is connected to the limiter 201 and the input impedance matching network 204 is connected to the limiter 202);
- a differential amplifier 205 comprising
   - a first transistor FET1, which is a Field-Effect Transistor (FET), preferably an n-channel, depletion mode pHEMT, and which has a respective gate electrode G1 connected to the input impedance matching network 203, and respective drain and source electrodes denoted, respectively, as D1 and S1, and
   - a second transistor FET2, which is a FET, preferably an n-channel, depletion mode pHEMT, and which has a respective gate electrode G2 connected to the input impedance matching network 204, a respective source electrode S2 connected to the source electrode S1 of the first transistor FET1, and a respective drain electrode denoted as D2;
- a first matching and biasing network 206 connected to the drain electrode D1 of the first transistor FET1;
- a second matching and biasing network 207 connected between the drain electrode D2 of the second transistor FET2 and a load impedance 208 connected to ground, conveniently a load impedance of 50 Ω;
- a single-ended broadband amplifier 209 comprising a respective transistor FET3, which is a FET, preferably an n-channel, depletion mode pHEMT, and which has a respective gate electrode G3 connected to the first matching and biasing network 206, and respective drain and source electrodes denoted, respectively, as D3 and S3;
- an output matching and biasing network 210 connected between the drain electrode D3 of the transistor FET3 of the single-ended broadband amplifier 209 and the output port P_{OUT}; and
- a biasing network 211 connected between the output matching and biasing network 210, and the first matching and biasing network 206 and the second matching and biasing network 207.

The group comprising the two input impedance matching networks 203 and 204, the differential amplifier 205, the first matching and biasing network 206 and the second matching and biasing network 207 is designed so as to form an active balun which:
- in use carries out balanced-to-unbalanced signal conversion, i.e., converts the differential (i.e., balanced) microwave incoming signals received from the microwave UWB antenna (through the limiters 201 and 202 and the input impedance matching networks 203 and 204) to corresponding unbalanced microwave signals outputted through the first matching and biasing network 206;
- is realized by means of lumped passive and active elements integrated in a MMIC, preferably a MMIC manufactured by using GaAs pHEMT technology; and
- is equipped with input and output matching circuitry (i.e., the two input impedance matching networks 203 and 204, and the first and second matching and biasing networks 206 and 207, respectively) that includes lumped passive elements.

In the following the components of the MMIC 200 will be described in greater detail along with respective operation.

The limiters 201 and 202 are conveniently realized with a series of GaAs protection diodes manufactured by using a GaAs pHEMT 0.15 µm gate production process, shunting the access lines. The limiters 201 and 202 are designed to protect the active and passive components arranged downstream, in particular active and passive components of the balun, from strong continuous wave or pulse signals received by the microwave UWB antenna and having frequencies included in the antenna band. The diodes have a very limited impact on the performances of the active balun for low-level signals, while effectively shunting high voltages to ground.

The input impedance matching networks 203 and 204 are lumped circuits designed to match the impedance of the microwave UWB antenna (such as the aforesaid input impedance of 150 Ω) to the impedance of the differential amplifier 205 minimizing noise figure and optimizing gain.

The differential amplifier 205 is designed for common-mode rejection and substantial differential gain. Conveniently, the transistors FET1 and FET2 have, each, a respective shunt RC feedback (in particular, as shown in Figure 2, a respective resistor R1/R2 and a respective capacitor C1/C2 in series between the respective drain electrode D1/D2 and the respective gate electrode G1/G2) in order to get a relatively low noise figure together with a good input match to increase circuit stability so as to render the device unconditionally stable. Again conveniently, the transistors FET1 and FET2 have, each, a respective large bias resistor R3/R4 (for example with resistance comprised in the range 500-1000 Ω) between the respective gate electrode G1/G2 and ground, and a self-bias series resistor R5 between the source electrodes S1 and S2 and ground, also providing common-mode rejection.

As previously explained, the differential amplifier 205 has an unbalanced output, wherein:
- the drain electrode D2 of the second transistor FET2 is connected to the second matching and biasing network 207, which is designed to perform impedance matching between said second transistor FET2 and the load impedance 208 (which, as previously said, is conveniently an impedance of 50 Ω); and
- the drain electrode D1 of the first transistor FET1 is connected to the single-ended broadband amplifier 209 through the first matching and biasing network 206, which is designed for gain flatness across the operating band and to perform impedance matching between said first transistor FET1 and said single-ended broadband amplifier 209.

Conveniently, the transistor FET3 of the single-ended broadband amplifier 209 has a larger size than the first and second transistors FET1 and FET2 of the differential amplifier 205, and is biased at higher drain voltage and current, for linearity. In particular, as for linearity parameter, the MMIC 200 is preferably designed to operate in its linear region up to an input power of 0 dBm and, thence, the transistor FET3 of the single-ended broadband amplifier 209 is sized larger than the first and second transistors FET1 and FET2 of the differential amplifier 205 so as to have an output compression point of the order of 15 dBm.

Conveniently, the transistor FET3 of the single-ended broadband amplifier 209 has a large bias resistor R6 (for example with resistance comprised in the range 500-1000 Ω) between the respective gate electrode G3 and ground, and a series self-bias resistor R7 between the respective source electrode S3 and ground, wherein said series self-bias resistor R7 is shunted by a large capacitor C3 (for example with capacitance comprised in the range 10-20 pF) in parallel, for common-source operation.

As previously described, the drain electrode D3 of the transistor FET3 of the single-ended broadband amplifier 209 is connected to a microwave transmission line, preferably a coaxial cable, through the output matching and biasing network 210, which is designed to:
- perform impedance matching between said transistor FET3 of the single-ended broadband amplifier 209 and said microwave transmission line, which preferably has an input impedance of 50 Ω;
- receive a DC power supply from said microwave transmission line, preferably taking said DC power supply from the central conductor of the coaxial cable;
- bias, on the basis of said DC power supply, the transistor FET3 of the single-ended broadband amplifier 209 at the drain electrode D3 of said transistor FET3; and
- provide the biasing network 211 with said DC power supply.

Moreover, said biasing network 211 is designed to provide the first matching and biasing network 206 and the second matching and biasing network 207 with said DC power supply, said first matching and biasing network 206 is further designed to bias, on the basis of said DC power supply, the first transistor FET1 of the differential amplifier 205 at the drain electrode D1 of said first transistor FET1, and said second matching and biasing network 207 is further designed to bias, on the basis of said DC power supply, the second transistor FET2 of the differential amplifier 205 at the drain electrode D2 of said second transistor FET2.

In particular, the bias circuitry formed by the output matching and biasing network 210, the biasing network 211, the first matching and biasing network 206 and the second matching and biasing network 207 is designed to provide proper biasing to both the differential amplifier 205 and the single-ended broadband amplifier 209 on the basis of a single DC power supply directly taken from the microwave transmission line coupled with the output port P_{OUT}. Moreover, said bias circuitry is designed so as to avoid any dangerous RF return path that could generate instabilities. To this end, said bias circuitry conveniently includes a suitable RF ground and effective LRC low-pass filters.

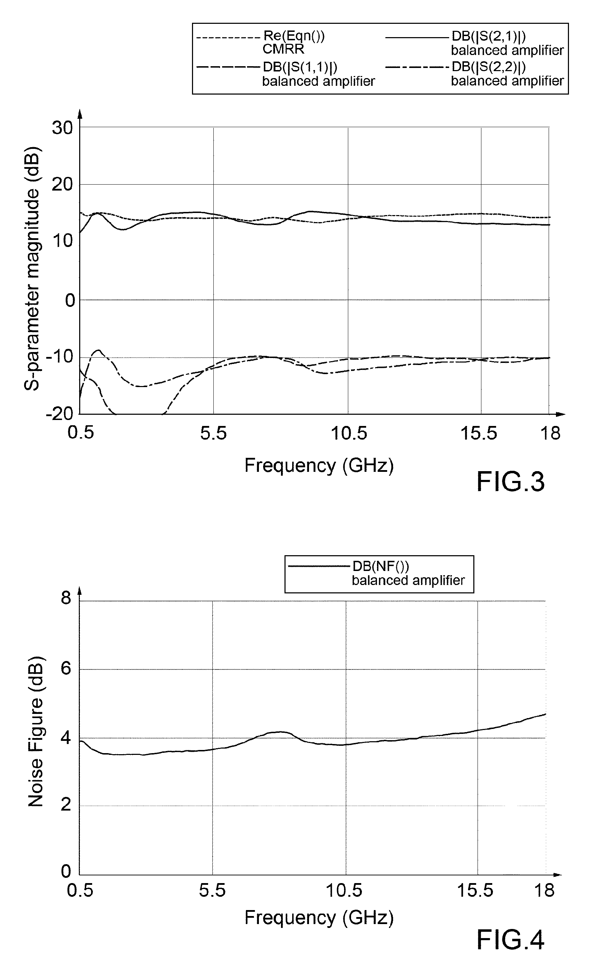

The MMIC 200 has been manufactured by the Applicant using a model library of a GaAs pHEMT foundry and, then, deeply tested by using a three-port Vector Network Analyzer for calibrated S-parameter measurement with a balanced input and single-ended output. In this respect, Figures 3 and 4 show, respectively, S-parameters and Noise Figure of the manufactured MMIC with respect to operating frequency range 0.5-18 GHz. In particular, as shown in Figures 3 and 4, an average Gain of 13dB and Return Loss better than 10dB have been measured, the Common Mode Rejection is better than 20dB across the whole band, and the Noise Figure is less than 5dB for the whole 0.5-18 GHz frequency range. Therefore, the testing of the MMIC 200 has provided excellent results.

The advantages of the present invention are clear from the foregoing.

In particular, it is worth highlighting the fact that the present invention allows the integration on one and the same MMIC of all the four functions necessary in microwave UWB reception, i.e., balanced-to-unbalanced signal conversion, impedance matching, protection against high-level signals, and broadband low-noise amplification. In fact, as previously described, the MMIC according to the present invention includes a protection from the presence of high-level signals, an active balun circuit, an ultra-wideband amplifier circuit, and a transformer circuit, wherein all the active components are fed using a single DC power supply.

Moreover, as previously explained, the MMIC according to the present invention provides an extremely wide frequency coverage, in particular it operates with a bandwidth from 0.5 GHz to 18.0 GHz always providing excellent performances.

Therefore, the present invention makes it possible to realize a product characterized by a high integration factor that reduces cost, size and weight, increases frequency coverage and improves performance of microwave UWB front-end modules.

The present invention can be advantageously exploited in UWB EW systems, UWB ECM systems, UWB direction finding systems, phased array systems and multi-function Active Electronically Scanned Array (AESA) systems.

Finally, it is clear that numerous modifications and variants can be made to the present invention, all falling within the scope of the invention, as defined in the appended claims.

## Claims

1. Monolithic microwave integrated circuit (200), including:
• an input stage designed to be connected to a microwave antenna to receive therefrom a balanced microwave signal;
• a differential amplifier (205) connected to the input stage and designed to output, in response to reception of the balanced microwave signal, a corresponding unbalanced microwave signal;
• a single-ended amplifier (209) connected to the differential amplifier (205) and designed to amplify the unbalanced microwave signal outputted by the latter;
• an output matching and biasing network (210), which is connected to the single-ended amplifier (209) to receive therefrom the amplified balanced microwave signal, and which is designed to
- be connected to a microwave transmission line to provide the latter with said amplified unbalanced microwave signal and receive therefrom a direct current power supply,
- perform impedance matching between the single-ended amplifier (209) and said microwave transmission line, and
- bias the single-ended amplifier (209) on the basis of the direct current power supply; and
• a biasing network (211), which is connected to the output matching and biasing network (210) to receive therefrom said direct current power supply, and which is designed to bias the differential amplifier (205) on the basis of said direct current power supply.

2. The monolithic microwave integrated circuit of claim 1, wherein the input stage includes:
• two input ports (P_{IN-1}, P_{IN-2}) designed to be coupled with the microwave antenna to receive the balanced microwave signal;
• two limiters (201,202), each connected to a respective one of the two input ports (P_{IN-1}, P_{IN-2}) ; and
• two input impedance matching networks (203,204), each of which is connected between
- a respective one of the two limiters (201,202), and
- a respective input of the differential amplifier (205) ;
and wherein the input impedance matching networks (203,204) are designed to perform impedance matching between the microwave antenna and the differential amplifier (205).

3. The monolithic microwave integrated circuit of claim 2, wherein:
• the differential amplifier (205) includes a first field-effect transistor (FET1) and a second field-effect transistor (FET2), each of which has respective gate, drain and source electrodes (G1,G2;D1,D2;S1,S2);
• the single-ended amplifier (209) includes a third field-effect transistor (FET3) having respective gate, drain and source electrodes (G3;D3;S3);
• the gate electrodes (G1,G2) of the first (FET1) and second (FET2) field-effect transistors are connected, each, to a respective one of the two input impedance matching networks (203,204) to receive the balanced microwave signal;
• the source electrode (S1) of the first field-effect transistor (FET1) is connected to the source electrode (S2) of the second field-effect transistor (FET2);
• the drain electrode (D1) of the first field-effect transistor (FET1) is connected to the gate electrode (G3) of the third field-effect transistor (FET3) through a first matching and biasing network (206) to provide said third field-effect transistor (FET3) with the unbalanced microwave signal;
• the drain electrode (D2) of the second field-effect transistor (FET2) is connected to a grounded impedance (208) through a second matching and biasing network (207);
• the output matching and biasing network (210) is connected to the drain electrode (D3) of the third field-effect transistor (FET3) to receive therefrom the amplified unbalanced microwave signal and to bias said third field-effect transistor (FET3);
• the first matching and biasing network (206) is connected to the biasing network (211) to receive therefrom the direct current power supply, and is designed to
- perform impedance matching between the first field-effect transistor (FET1) and the third field-effect transistor (FET3), and
- bias the first field-effect transistor (FET1) on the basis of said direct current power supply; and
• the second matching and biasing network (207) is connected to the biasing network (211) to receive therefrom the direct current power supply, and is designed to
- perform impedance matching between the second field-effect transistor (FET2) and the grounded impedance (208), and
- bias the second field-effect transistor (FET2) on the basis of said direct current power supply.

4. The monolithic microwave integrated circuit of claim 3, wherein the first (FET1), second (FET2) and third (FET3) field-effect transistors are n-channel, depletion mode pseudomorphic high-electron-mobility transistors.

5. The monolithic microwave integrated circuit of claim 4, wherein said n-channel, depletion mode pseudomorphic high-electron-mobility transistors are based on gallium arsenide.

6. The monolithic microwave integrated circuit according to any claim 3-5, wherein the differential amplifier (205) further includes:
• a first resistor (R1) and a first capacitor (C1) connected in series between the drain (D1) and gate (G1) electrodes of the first field-effect transistor (FET1);
• a second resistor (R2) and a second capacitor (C2) connected in series between the drain (D2) and gate (G2) electrodes of the second field-effect transistor (FET2);
• a third resistor (R3) connected between the gate electrode (G1) of the first field-effect transistor (FET1) and ground;
• a fourth resistor (R4) connected between the gate electrode (G2) of the second field-effect transistor (FET2) and ground; and
• a fifth resistor (R5) connected between the source electrodes (S1,S2) of the first (FET1) and second (FET2) field-effect transistors and ground;
and wherein the single-ended amplifier (209) further includes:
• a sixth resistor (R6) connected between the gate electrode (G3) of the third field-effect transistor (FET3) and ground; and
• a seventh resistor (R7) and a third capacitor (C3) connected in parallel between the source electrode (S3) of the third field-effect transistor (FET3) and ground.

7. The monolithic microwave integrated circuit according to any claim 3-6, wherein the third field-effect transistor (FET3) has a larger size and is designed to be biased at higher drain voltage and current than the first (FET1) and second (FET2) field-effect transistors.

8. The monolithic microwave integrated circuit according to any claim 2-7, wherein the limiters (201,202) include protection diodes based on gallium arsenide.

9. The monolithic microwave integrated circuit according to any preceding claim, wherein said monolithic microwave integrated circuit (200) is designed to be coupled with an antenna designed to receive microwave signals having frequencies comprised in the range 0.5-18 GHz.

10. The monolithic microwave integrated circuit according to any preceding claim, wherein the output matching and biasing network (210) is designed to be connected to a coaxial cable and to take the direct current power supply from a central conductor of said coaxial cable.

11. Receiving system comprising the monolithic microwave integrated circuit (200) claimed in any preceding claim.

12. The receiving system of claim 11, further comprising:
• a microwave antenna connected to the input stage of the monolithic microwave integrated circuit (200);
• a microwave transmission line connected to the output matching and biasing network (210) of the monolithic microwave integrated circuit (200); and
• a receiving module connected to the microwave transmission line.

13. The receiving system of claim 12, wherein the microwave antenna is designed to receive microwave signals having frequencies comprised in the range 0.5-18 GHz.

14. The receiving system according to claim 12 or 13, wherein the microwave antenna is a planar self-complementary antenna.

15. The receiving system according to any claim 12-14, wherein the microwave transmission line is a coaxial cable.
